# EUROPÄISCHE PATENTANMELDUNG

(11) **EP 4 756 662 A1**
(43) Veröffentlichungstag der Anmeldung: **10.06.2026**
(21) Anmeldenummer: 24218477.8
(22) Anmeldetag: 09.12.2024
(51) Int. Cl.: G06F 30/23

(54) **FERTIGUNGSTOLERANZEN FÜR EIN LEHRZAHNRAD**

(71) Anmelder: Klingelnberg AG, 8050 Zürich (CH)
(72) Erfinder: Landvogt, Alexander, 35519 Rockenberg (DE)
(74) Vertreter: Janke Scholl Patentanwälte PartG mbB

(57) **Zusammenfassung**

Verfahren, mit den Verfahrensschritten: Definieren von Fertigungstoleranzen als zulässige Abweichungen von einer vor-gegebenen Soll-Geometrie (4) eines Lehrzahnrads (2), welches ein Lehrzahnrad (2) für eine Wälzprüfung ist, wobei zum Definieren der Fertigungstoleranzen eine Worst-Case-Beurteilung für zwei oder mehr Geometrieabweichungsparameter einer Verzahnung (17) des Lehrzahnrads (2) und/oder eines zugeordneten Gegenrads (18) mittels computer-implementierter Zahnkontaktanalyse (20) derart durchgeführt wird, dass eine berechnete Abweichung mindestens eines Wertes eines Prüfmerkmals der Wälzprüfung, die aus den Geometrieabweichungsparametern resultiert, kleiner ist als ein vorgegebener Grenzwert, wobei die computerimplementierte Zahnkontaktanalyse (20) ein Kl-Modell (24) aufweist, das anhand von Trainingsdaten (26, 28) trainiert worden ist, wobei die Trainingsdaten (26, 28) Werte eines Prüfmerkmals oder mehrerer Prüfmerkmale einer Wälzprüfung von Geometrieabweichungsparameter aufweisenden Verzahnungen aufweisen, wobei diese Werte in simulationsbasierten Zahnkontaktanalysen und/oder prüfstandsbasiert ermittelt worden sind, und wobei die Trainingsdaten (26, 28) die diesen Werte zugeordneten Geometrien der Geometrieabweichungsparameter aufweisenden Verzahnungen aufweisen.

## Beschreibung

Die vorliegende Erfindung betrifft ein Verfahren zum Definieren von Fertigungstoleranzen für eine Soll-Geometrie eines Lehrzahnrads, welches ein Lehrzahnrad für eine Wälzprüfung ist. Weiter betrifft die Erfindung eine Vorrichtung zum Definieren von Fertigungstoleranzen für eine Soll-Geometrie eines Lehrzahnrads.

Die Wälzprüfung dient z.B. zum Prüfen des Drehfehlers und des Geräuschverhaltens von Laufverzahnungen. Es wird zwischen der Einflankenwälzprüfung und der Zweiflankenwälzprüfung unterschieden.

Das Grundprinzip der Einflankenwälzprüfung beruht darauf, dass ein Lehrzahnrad, d.h. ein nahezu fehlerfreies Zahnrad, und das zu prüfende Zahnrad mit einem festen Achsabstand abwälzen. Durch eine gebremste Achse wird erreicht, dass beim Abwälzen nur eine Flankenseite, d.h. die Links- oder Rechtsflanke, im Eingriff ist. Fehler in der Drehübertragung werden durch Winkelmesssysteme, Drehbeschleunigungsaufnehmer und Schwingungsaufnehmer gemessen.

Für die Zweiflankenwälzprüfung gilt, dass das zu prüfende Zahnrad und das Lehrzahnrad einen dynamischen Achsabstand zueinander aufweisen, wobei das zu prüfende Zahnrad und das Lehrzahnrad in einem Zweiflankenkontakt sind, d.h. die Links- und Rechtsflanke gleichzeitig im Eingriff sind. Das Lehrzahnrad ist dabei an einem linear verschiebbaren Prüfschlitten gehalten. Das prüfende Zahnrad wird angetrieben und das Lehrzahnrad wird mit definierter Kraft in den Zweiflankenkontakt gepresst. Durch geometrische Fehler oder Beschädigungen der Verzahnung des zu prüfenden Zahnrads verschiebt sich der Prüfschlitten mit dem Lehrzahnrad, wobei diese Verschiebung aufgezeichnet und ausgewertet wird.

Die Qualität der Messergebnisse der Wälzprüfung hängt entscheidend davon ab, dass das Lehrzahnrad nur Fertigungsabweichungen in einer solchen Größenordnung aufweist, die zu keiner signifikanten Veränderung der Messergebnisse der Wälzprüfung führen, insbesondere bei der Einflankenwälzprüfung, d.h. der Drehfehlermessung. Mit anderen Worten soll für den Fall, dass ein und dieselbe zu prüfende Verzahnung gegen zwei baugleiche Lehrzahnräder getestet wird, im Rahmen der Wälzprüfung das gleiche Testergebnis herauskommen. Baugleiche Lehrzahnräder sind bezüglich ihrer Soll-Geometrie identisch und unterscheiden sich nur durch Fertigungsabweichungen innerhalb der vorgegebenen Fertigungstoleranzen voneinander.

Um sicherzustellen, dass ein gefertigtes Lehrzahnrad für die Wälzprüfung und zur Messung von Drehfehlern geeignet ist, müssen diese Fertigungstoleranzen für das Lehrzahnrad derart definiert werden, dass der Einfluss von Fertigungsabweichungen des Lehrzahnrads auf das Messergebnis geringgehalten bzw. in einem vorgegebenen Bereich gehalten werden.

Um diese Fertigungstoleranzen zu definieren, kann eine Worst-Case Beurteilung von Fertigungstoleranzen durchgeführt werden. Mit dieser Worst-Case Beurteilung kann nachgewiesen werden, dass für vorgegebene Fertigungstoleranzen im schlechtesten Fall z.B. der gemessene Drehfehler nicht mehr als ein vorgegebener Prozentsatz von einem simulationsbasierten, mittels Zahnkontaktanalyse berechneten Drehfehler für ein abweichungsfreies Lehrzahnrad abweicht, sofern diese Fertigungstoleranzen eingehalten werden.

Mit anderen Worten können für die Worst-Case-Beurteilung alle Kombinationen von Fertigungsabweichungen innerhalb eines vorgegebenen Toleranzbereichs mittels Zahnkontaktanalyse berechnet werden, wobei im Ergebnis derjenige Fall als schlechtester Fall bewertet wird, für den der berechnete Drehfehler am stärksten von einem Soll-Drehfehler abweicht, wobei sich der Soll-Drehfehler für eine fertigungsfehlerfreie Verzahnung ergeben würde. Wird festgestellt, dass selbst für diesen schlechtesten Fall ein akzeptabler Einfluss der Fertigungsabweichungen des Lehrzahnrads auf die Ergebnisse der Wälzprüfung berechnet worden ist, sind die festgelegten Fertigungstoleranzen dazu geeignet, für die Fertigung des Lehrzahnrads verwendet zu werden.

Für die Worst-Case-Beurteilung müssen daher verschiedene Kombinationen von Fertigungsabweichungen einer Verzahnung des Lehrzahnrads in verschiedenen Ausprägungen bzw. Abstufungen mittels Zahnkontaktanalyse berechnet werden, die innerhalb eines vorgegebenen Toleranzbereichs liegen.

Der Begriff der "Worst-Case-Beurteilung" bedeutet zu Deutsch die Betrachtung des schlechtesten möglichen Falls, d.h. vorliegend die ungünstigste Kombination von Fertigungsabweichungen des Lehrzahnrads und/oder des zugeordneten Gegenrads, die in der Folge den größten Einfluss auf das Messergebnis hätten.

Mit bekannten Methoden der simulationsbasierten Zahnkontaktanalyse wird sehr viel Rechenzeit benötigt, um eine deratige Worst-Case Beurteilung durchzuführen. Beispielsweise ergibt sich für jeweils fünf Geometrieabweichungsparameter für das Lehrzahnrad und das zugeordnete Gegenrad und bei einer Abstufung der Geometrieabweichungsparameter in drei Stufen zu +1/0/-1 µm eine Variantenanzahl von 3exp10 = 59049 Varianten. Für eine Abstufung der Geometrieabweichungsparameter in fünf Stufen zu +2/+1/0/-1/-2 µm ergibt sich bereits eine Variantenanzahl von 5exp10 = 9765625. Bei einer Rechenzeit von ca. 75 Sekunden pro simulationsbasierter Zahnkontaktanalyse beträgt die Rechenzeit für die genannten Beispiele 51 Tage bzw. 8477 Tage. Eine solche Berechnung von simulationsbasierten Zahnkontaktanalysen ist daher in der betrieblichen Praxis nicht geeignet, um Fertigungstoleranzen im Rahmen einer Auslegung eines Lehrzahnrads zu ermitteln.

Die Festlegung von Fertigungstoleranzen im Rahmen einer Auslegung eines Lehrzahnrads erfolgt daher derzeit basierend auf Erfahrungswerten und es werden im Trialand-Error Verfahren eine Vielzahl von Lehrzahnrädern gefertigt, bis ein geeignetes Lehrzahnrad hergestellt worden ist. Es versteht sich, dass dieses Vorgehen zeitaufwändig ist und ggf. eine große Anzahl von Schlechtteilen produziert werden.

Vor diesem Hintergrund liegt der vorliegend Erfindung die technische Problemstellung zugrunde, ein verbessertes und insbesondere effizienteres Verfahren zum Definieren von Fertigungstoleranzen für ein Lehrzahnrad anzugeben. Weiter soll eine Vorrichtung zum Definieren von Fertigungstoleranzen für ein Lehrzahnrad angegeben werden.

Die voranstehend beschriebene, technische Problemstellung wird jeweils mit den Merkmalen der unabhängigen Ansprüche gelöst. Weitere Ausgestaltungen ergeben sich aus den abhängigen Ansprüchen und der nachstehenden Beschreibung.

Gemäß einem ersten Aspekt betrifft die Erfindung ein Verfahren, mit den Verfahrensschritten: Definieren von Fertigungstoleranzen als zulässige Abweichungen von einer vorgegebenen Soll-Geometrie eines Lehrzahnrads, welches ein Lehrzahnrad für eine Wälzprüfung ist, wobei zum Definieren der Fertigungstoleranzen eine Worst-Case-Beurteilung für zwei oder mehr Geometrieabweichungsparameter einer Verzahnung des Lehrzahnrads und/oder eines zugeordneten Gegenrads mittels computerimplementierter Zahnkontaktanalyse derart durchgeführt wird, dass eine berechnete Abweichung mindestens eines Wertes eines Prüfmerkmals der Wälzprüfung, die aus den Geometrieabweichungsparametern resultiert, kleiner ist als ein vorgegebener Grenzwert, wobei die computerimplementierte Zahnkontaktanalyse ein KI-Modell aufweist, das anhand von Trainingsdaten trainiert worden ist, wobei die Trainingsdaten Werte eines Prüfmerkmals oder mehrerer Prüfmerkmale einer Wälzprüfung von Geometrieabweichungsparameter aufweisenden Verzahnungen aufweisen, wobei diese Werte in simulationsbasierten Zahnkontaktanalysen und/oder prüfstandsbasiert ermittelt worden sind, und wobei die Trainingsdaten die diesen Werte zugeordneten Geometrien der Geometrieabweichungsparameter aufweisenden Verzahnungen aufweisen.

Geometrieabweichungsparameter der Verzahnung des Lehrzahnrads und/oder des zugeordneten Gegenrads, die in der Worst-Case-Beurteilung berücksichtigt werden bzw. die für die Worst-Case Beurteilung vorgegeben werden, sind z.B. ausgewählt aus: Teilungs-Einzelabweichung; Teilungs-Gesamtabweichung; Rundlaufabweichung; Zahndickenabweichung; Profil-Winkelabweichung; Profil-Formabweichung; Profil-Gesamtabweichung; Flankenlinienwinkelabweichung; Flankenlinienformabweichung; Flankenliniengesamtabweichung; Kopfrücknahme; Fußrücknahme; Profil-Winkelmodifikation; Höhenballigkeit; Endenrücknahme; Flankenlinienwinkelmodifikation; Breitenballigkeit; Profilverschränkung; Flankenlinienverschränkung.

Das zugeordnete Gegenrad kann im Rahmen der computerimplementierter Zahnkontaktanalyse die zu prüfende Verzahnung repräsentieren. Die Worst-Case-Beurteilung berücksichtigt insbesondere nicht nur den Einfluss von Geometrieabweichungsparametern des Lehrzahnrads beim Abwälzen mit einem perfekten Gegenrad bzw. Prüfling, sondern berücksichtigt bevorzugt auch den Einfluss der Wechselwirkung verschiedener Geometrieabweichungsparameter des Lehrzahnrads und des Gegenrads.

Insbesondere werden Geometrieabweichungsparameter des Gegenrads im Toleranzbereich der in der Praxis zu prüfenden Verzahnung festgelegt.

Prüfmerkmale der Wälzprüfung, die in der Worst-Case-Beurteilung berücksichtigt werden bzw. die für die Worst-Case Beurteilung vorgegeben werden, sind z.B. ausgewählt aus: Drehfehler, Achsabstand, Rundlauf, Wälzsprung, Wälzabweichung, Zweikugelmaß, Rundlauffehler, Zahn-zu-Zahn Amplitude (langwellige und kurzwellige), maximale Wälzabweichung, Transmission Error und dynamic Backlash, Geräuschverhalten, Oberflächenfehler.

Wenn vorliegend von einer berechneten Abweichung mindestens eines Wertes eines Prüfmerkmals der Wälzprüfung gesprochen wird, die aus den Geometrieabweichungsparametern resultiert, so wird diese Abweichung im Vergleich zu einem fehlerfreien Lehrzahnrad und fehlerfreien Gegenrad berechnet. D.h. es werden Werte eines Prüfmerkmals der Wälzprüfung für ein fehlerfreies Lehrzahnrad und ein fehlerfreies Gegenrad, die exakt ihrer vorgegebenen Soll-Geometrie entsprechen, als Referenz verwendet, um den Einfluss der Geometrieabweichungsparameter eines nicht-fehlerfreien Lehrzahnrads auf das Ergebnis der Wälzprüfung zu ermitteln.

Die Verwendung des KI-Modells ermöglicht die Reduzierung der Rechenzeit zur Festlegung der Fertigungstoleranzen um ein Vielfaches, da auf zeitintensive, simulationsbasierte Zahnkontaktanalysen verzichtet werden kann.

Eingangsdaten des KI-Modells sind beispielsweise die Soll-Geometrie bzw. Verzahnungsdaten des Lehrzahnrads, wie Modul, Zähnezahl, Schrägungswinkel, Modifikationen etc., sowie zwei oder mehr Geometrieabweichungsparameter von dieser Soll-Geometrie jeweils in vorgegebenen Abstufungen.

Eingangsdaten des KI-Modells sind beispielsweise die Soll-Geometrie bzw. Verzahnungsdaten des Gegenrads, wie Modul, Zähnezahl, Schrägungswinkel, Modifikationen etc., sowie zwei oder mehr Geometrieabweichungsparameter von dieser Soll-Geometrie jeweils in vorgegebenen Abstufungen.

Ausgangsdaten des KI-Modells sind z.B. zu erwartende Abweichungen für eines oder für mehrere Prüfmerkmale der Wälzprüfung, die aus diesen Geometrieabweichungsparametern resultieren. Der Vorteil der Verwendung des KI-Modells ist, dass die Rechenzeit für die ausgewählten Kombinationen und Abstufungen der Geometrieabweichungsparameter deutlich verkürzt werden kann.

Es kann vorgesehen sein, dass für ein jeweiliges Prüfmerkmal der Wälzprüfung ein spezifisches nur für dieses Prüfmerkmal trainiertes KI-Modell vorgesehen ist. Es können daher mehrere KI-Modelle vorgesehen sein, die jeweils bezüglich verschiedener Prüfmerkmale der Wälzprüfung trainiert worden sind.

Beispielsweise kann ein KI-Modell vorgesehen sein, das eigens dazu eingerichtet ist, einen zu erwartenden Drehfehler, der aus zwei oder mehr Geometrieabweichungsparametern des Lehrzahnrads und/oder des Gegenrads resultiert, zu bestimmen. Dies gilt gleichermaßen für die weiteren genannten Prüfmerkmale der Wälzprüfung.

Die Worst-Case-Beurteilung kann eine Durchführung mehrerer computerimplementierter Zahnkontaktanalysen für verschiedene Kombinationen und Ausprägungen von Geometrieabweichungsparametern aufweisen. D.h. die Anzahl der zu betrachtenden bzw. zu berechnenden Versuchspunkte wird durch die Verwendung des KI-Modells nicht reduziert, sondern lediglich die Rechenzeit je Versuchspunkt.

Es kann vorgesehen sein, dass für mindestes einen der Geometrieabweichungsparameter oder für jeden der Geometrieabweichungsparameter zumindest zwei Ausprägungen angegebenen werden, insbesondere bis zu zehn Ausprägungen angegebenen werden, weiter insbesondere bis zu fünf Ausprägungen angegebenen werden.

Eine jeweilige Ausprägung für einen jeweiligen Geometrieabweichungsparameter kann als Abweichung in einer Maßeinheit bezogen auf die Sollgeometrie angegeben werden. Insbesondere kann eine jeweilige Ausprägung als Abstufung innerhalb eines vorgegebenen Wertebereichs des jeweiligen Geometrieabweichungsparameters angegeben werden.

Das KI-Modell kann aus den folgenden Modelltypen ausgewählt sein bzw. auf folgenden Rechenverfahren basieren, wobei, wie bereits erwähnt, mehrere KI-Modelle Teil der computerimplementierten Zahnkontaktanalyse sein können: neuronales Netz, insbesondere tiefes oder flaches neuronales Netz, Radiale Basisfunktion, Kriging, Relevance Vector Regression, Random Forrest Regression, Taylor Polynom, Optimale Response Surface Modelling, Akaike information criterion.

Es kann vorgesehen sein, dass vor dem Definieren von Fertigungstoleranzen eine Auslegung der Soll-Geometrie erfolgt.

Weiter kann vorgesehen sein, dass nach dem Definieren der Fertigungstoleranzen eine Fertigung des Lehrzahnrads unter Einhaltung der definierten Fertigungstoleranzen erfolgt.

Gemäß einem zweiten Aspekt betrifft die Erfindung eine Vorrichtung, mit einem Softwareprogrammprodukt, eingerichtet zur Ausführung eines erfindungsgemäßen Verfahrens.

Nachfolgend wird die Erfindung anhand einer Ausführungsbeispiele darstellenden Zeichnung näher erläutert. Es zeigen jeweils schematisch:
- Fig. 1: ein Lehrzahnrad;
- Fig. 2: Verfahrensschritte eines erfindungsgemäßen Verfahrens;
- Fig. 3: eine Vorrichtung zum Ausführen des erfindungsgemäßen Verfahrens gemäß Fig. 1.

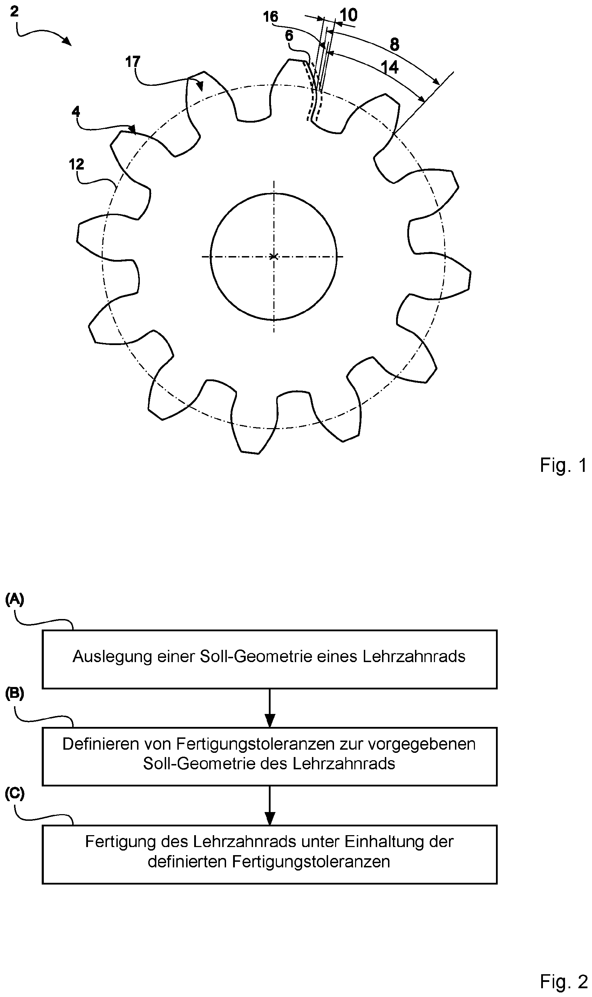

Fig. 1 zeigt exemplarisch und schematisch ein Lehrzahnrad 2 mit einer Soll-Geometrie 4, anhand dessen ein erfindungsgemäßes Verfahren näher erläutert wird. Fig. 2 zeigt Verfahrensschritte des erfindungsgemäßen Verfahrens.

Das Verfahren umfasst die Verfahrensschritte: (A) Auslegung der Soll-Geometrie 4 des Lehrzahnrads 2; (B) Definieren von Fertigungstoleranzen zur vorgegebenen Soll-Geometrie 4 des Lehrzahnrads 2; (C) Fertigung des Lehrzahnrads 2 unter Einhaltung der definierten Fertigungstoleranzen.

Fig. 1 zeigt schematisch und beispielhaft eine vorgegebene Soll-Teilung 8 als Verzahnungsparameter und damit als Teil der Soll-Geometrie 4 am Teilkreis 12. Für diese Soll-Teilung 8 soll z.B. ein Toleranzbereich 10 als Teil der einzuhaltenden Fertigungstoleranzen des Lehrzahnrads 2 definiert werden. Zahnflanken 6 des Lehrzahnrads 2 müssen sich somit nach der Fertigung des betreffenden Lehrzahnrads 2 innerhalb des Toleranzbereichs 10 befinden. Eine Abweichung 16 einer gefertigten Ist-Zahnteilung 14 von der vorgegebenen Soll-Teilung 8 kann als Teilungsfehler bezeichnet werden.

Ein solcher Teilungsfehler ist vorliegend lediglich zum besseren Verständnis der vorliegenden Erfindung als ein Beispiel für einen Geometrieabweichungsparameter des Lehrzahnrads 2 dargestellt worden. Für die nachfolgend noch näher beschriebene Worst-Case Beurteilung können mehrere Geometrieabweichungsparameter vorgegeben werden, z.B. ausgewählt aus: Teilungs-Einzelabweichung; Teilungs-Gesamtabweichung; Rundlaufabweichung; Zahndickenabweichung; Profil-Winkelabweichung; Profil-Formabweichung; Profil-Gesamtabweichung; Flankenlinienwinkelabweichung; Flankenlinienformabweichung; Flankenliniengesamtabweichung; Kopfrücknahme; Fußrücknahme; Profil-Winkelmodifikation; Höhenballigkeit; Endenrücknahme; Flankenlinienwinkelmodifikation; Breitenballigkeit; Profilverschränkung; Flankenlinienverschränkung. Diese Geometrieabweichungsparameter sind in der Verzahntechnik hinlänglich bekannt und werden daher vorliegend nicht näher beschrieben.

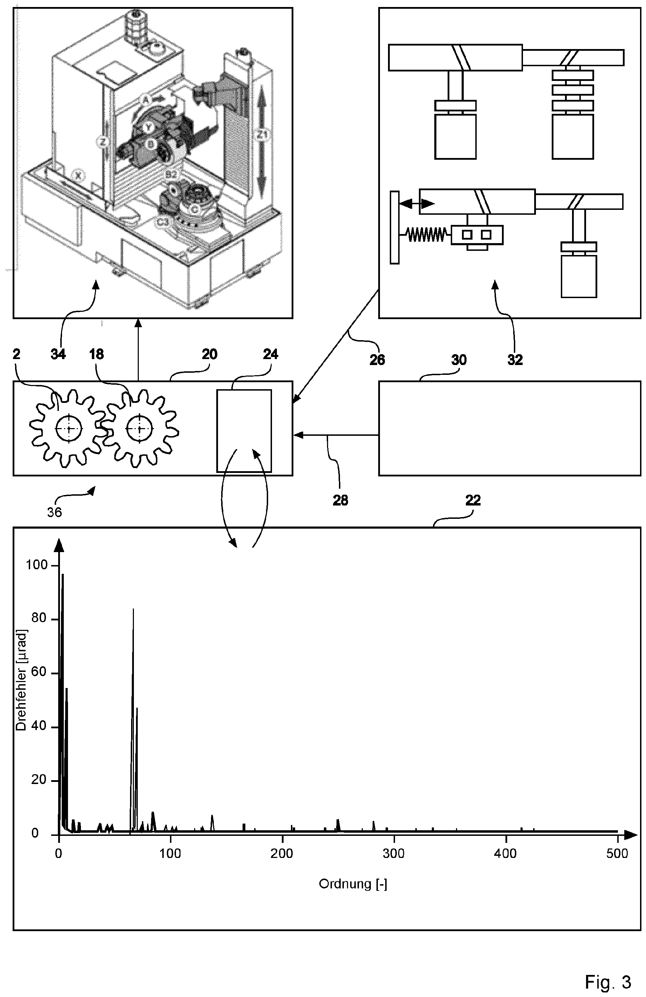

Zum Definieren der Fertigungstoleranzen wird eine Worst-Case-Beurteilung für zwei oder mehr Geometrieabweichungsparameter einer Verzahnung 17 des Lehrzahnrads 2 und/oder eines zugeordneten Gegenrads 18 (Fig. 3) mittels computerimplementierter Zahnkontaktanalyse 20 derart durchgeführt, dass eine berechnete Abweichung mindestens eines Wertes eines Prüfmerkmals der Wälzprüfung, die aus den Geometrieabweichungsparametern resultiert, kleiner ist als ein vorgegebener Grenzwert. Fig. 2 zeigt exemplarisch einen Drehfehler als Ordnungsspektrum 22, wobei für jede Ordnung ein solcher Grenzwert vorgegeben werden kann oder insgesamt ein max. zulässiger Drehfehler, der aus den Geometrieabweichungsparametern resultiert, als Grenzwert für den Drehfehler angegeben werden kann.

Neben dem Drehfehler können auch andere Prüfmerkmale der Wälzprüfung herangezogen werden, wie z.B.: Achsabstand, Rundlauf, Wälzsprung, Wälzabweichung, Zweikugelmaß, Rundlauffehler, Zahn-zu-Zahn Amplitude (langwellige und kurzwellige), maximale Wälzabweichung, Transmission Error und dynamic Backlash, Geräuschverhalten, Oberflächenfehler.

Die computerimplementierte Zahnkontaktanalyse 20 weist ein KI-Modell 24 auf.

Das KI-Modell 24 ist anhand von Trainingsdaten 26, 28 trainiert worden, wobei die Trainingsdaten 26, 28 Werte eines Prüfmerkmals oder mehrerer Prüfmerkmale einer Wälzprüfung von Geometrieabweichungsparameter aufweisenden Verzahnungen aufweisen, wobei diese Werte in simulationsbasierten Zahnkontaktanalysen 30 und/oder prüfstandsbasiert mithilfe von Wälzprüfständen 32 ermittelt worden sind, und wobei die Trainingsdaten 26, 28 die diesen Werte zugeordneten Geometrien der Geometrieabweichungsparameter aufweisenden Verzahnungen aufweisen.

Die Worst-Case-Beurteilung weist eine Durchführung mehrerer computerimplementierter Zahnkontaktanalysen 20 für verschiedene Kombinationen und Ausprägungen von Geometrieabweichungsparametern auf.

Für jeden der Geometrieabweichungsparameter werden zumindest zwei Ausprägungen angegebenen. Eine jeweilige Ausprägung für einen jeweiligen Geometrieabweichungsparameter wird als Abweichung in einer Maßeinheit bezogen auf die Sollgeometrie angegeben.

Im vorliegenden Beispiel wird der schlechteste Fall für jeweils fünf Geometrieabweichungsparameter für das Lehrzahnrad 2 und das Gegenrad 18, bei einer Abstufung der Geometrieabweichungsparameter in drei Stufen zu +1/0/-1 µm berechnet, d.h. eine Variantenanzahl von 3exp10 = 59049 Varianten, die jeweils mit dem KI-Modell 24 ausgewertet werden.

Das erfindungsgemäße Verfahren kann mittels einer Vorrichtung, wie einem Rechner 36, durchgeführt werden, mit einem Softwareprogrammprodukt, eingerichtet zur Ausführung des erfindungsgemäßen Verfahrens.

Nachdem die Fertigungstoleranzen festgelegt worden sind, kann das Lehrzahnrad 2 mittels einer Verzahnmaschine 34 gefertigt werden.

## Patentansprüche

1. Verfahren, mit den Verfahrensschritten:
- Definieren von Fertigungstoleranzen als zulässige Abweichungen von einer vorgegebenen Soll-Geometrie (4) eines Lehrzahnrads (2), welches ein Lehrzahnrad (2) für eine Wälzprüfung ist,
- wobei zum Definieren der Fertigungstoleranzen eine Worst-Case-Beurteilung für zwei oder mehr Geometrieabweichungsparameter einer Verzahnung (17) des Lehrzahnrads (2) und/oder eines zugeordneten Gegenrads (18) mittels computerimplementierter Zahnkontaktanalyse (20) derart durchgeführt wird,
- dass eine berechnete Abweichung mindestens eines Wertes eines Prüfmerkmals der Wälzprüfung, die aus den Geometrieabweichungsparametern resultiert, kleiner ist als ein vorgegebener Grenzwert,
- wobei die computerimplementierte Zahnkontaktanalyse (20) ein KI-Modell (24) aufweist, das anhand von Trainingsdaten (26, 28) trainiert worden ist, wobei die Trainingsdaten (26, 28) Werte eines Prüfmerkmals oder mehrerer Prüfmerkmale einer Wälzprüfung von Geometrieabweichungsparameter aufweisenden Verzahnungen aufweisen, wobei diese Werte in simulationsbasierten Zahnkontaktanalysen und/oder prüfstandsbasiert ermittelt worden sind, und wobei die Trainingsdaten (26, 28) die diesen Werte zugeordneten Geometrien der Geometrieabweichungsparameter aufweisenden Verzahnungen aufweisen.

2. Verfahren nach Anspruch 1,
**dadurch gekennzeichnet, dass**
die Worst-Case-Beurteilung eine Durchführung mehrerer computerimplementierter Zahnkontaktanalysen (20) für verschiedene Kombinationen und Ausprägungen von Geometrieabweichungsparametern aufweist.

3. Verfahren nach Anspruch 2,
**dadurch gekennzeichnet, dass**
für mindestes einen der Geometrieabweichungsparameter oder für jeden der Geometrieabweichungsparameter zumindest zwei Ausprägungen angegebenen werden, insbesondere bis zu zehn Ausprägungen angegebenen werden, weiter insbesondere bis zu fünf Ausprägungen angegebenen werden.

4. Verfahren nach einem der Ansprüche 2 oder 3,
**dadurch gekennzeichnet, dass**
eine jeweilige Ausprägung für einen jeweiligen Geometrieabweichungsparameter als Abweichung in einer Maßeinheit bezogen auf die Sollgeometrie angegeben wird, insbesondere, dass eine jeweilige Ausprägung als Abstufung innerhalb eines vorgegebenen Wertebereichs des jeweiligen Geometrieabweichungsparameters angegeben wird.

5. Verfahren nach einem der voranstehenden Ansprüche,
**dadurch gekennzeichnet, dass**
das KI-Modell (24) ausgewählt ist aus den folgenden Modelltypen und/oder auf folgenden Rechenverfahren basiert:
neuronales Netz, insbesondere tiefes oder flaches neuronales Netz, Radiale Basisfunktion, Kriging, Relevance Vector Regression, Random Forrest Regression, Taylor Polynome, Optimale Response Surface Modelling, Akaike information Criterion.

6. Verfahren nach einem der voranstehenden Ansprüche,
**dadurch gekennzeichnet, dass**
vor dem Definieren von Fertigungstoleranzen eine Auslegung der Soll-Geometrie erfolgt; und/oder
nach dem Definieren der Fertigungstoleranzen eine Fertigung des Lehrzahnrads (2) unter Einhaltung der definierten Fertigungstoleranzen erfolgt.

7. Vorrichtung,
mit einem Softwareprogrammprodukt, eingerichtet zur Ausführung eines Verfahrens nach einem der voranstehenden Ansprüche.
